(19) Europäisches Patentamt
European Patent Office
Office européen des brevets

(11) EP 4 648 075 A1

(12) EUROPEAN PATENT APPLICATION
published in accordance with Art. 153(4) EPC

(43) Date of publication:
12.11.2025 Bulletin 2025/46

(51) International Patent Classification (IPC):
H01G 4/236 (2006.01)   H01L 23/64 (2006.01)
H01G 4/12 (2006.01)

(21) Application number: 24738690.7

(22) Date of filing: 03.01.2024

(52) Cooperative Patent Classification (CPC):
H01G 4/12; H01G 4/236; H01L 23/64

(86) International application number:
PCT/KR2024/000081

(87) International publication number:
WO 2024/147619 (11.07.2024 Gazette 2024/28)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 05.01.2023 KR 20230001637

(71) Applicant: LG INNOTEK CO. LTD
Gangseo-gu
Seoul 07796 (KR)

(72) Inventors:
• PARK, Heun
Seoul 07796 (KR)
• CHOI, Yong Jae
Seoul 07796 (KR)
• KIM, Kab Young
Seoul 07796 (KR)

(74) Representative: DREISS Patentanwälte PartG
mbB
Friedrichstraße 6
70174 Stuttgart (DE)

(54) CAPACITOR

(57) A capacitor, according to an embodiment of the present invention, comprises: a base including a plurality of through-holes penetrating from a first surface to a second surface opposite to the first surface; a first electrode layer disposed on the first surface, the second surface, and inner walls of the plurality of through-holes of the base; a first dielectric layer disposed on the first electrode layer on the first surface, the second surface, and the inner walls of the plurality of through-holes of the base; and a second electrode layer disposed on the first dielectric layer on the first surface, the second surface, and the inner walls of the plurality of through-holes of the base.

[FIG. 3]
100

EP 4 648 075 A1

# Description

[Technical Field]

An embodiment of the present invention relates to a capacitor.

[Background Art]

A semiconductor package has been applied to various fields such as vehicles, communication, computers and generally includes a printed circuit bord, a semiconductor chip disposed on the printed circuit bord, and passive elements disposed on the printed circuit bord. For example, the passive elements may include resistors, inductors, capacitors, and the like.

As a semiconductor package becomes highly advanced, requirements for capacitors with high performance, high reliability, and ultra-small size are increasing. In order to satisfy such requirements, silicon-based capacitors and anodic aluminum oxide (AAO)-based capacitors are being proposed. A silicon-based capacitor includes an electrode layer, a dielectric layer, and an electrode layer which are sequentially stacked on a silicon base, and an AAO-based capacitor includes an electrode layer, a dielectric layer, and an electrode layer which are sequentially stacked on an AAO base.

Particularly, with an increase in needs for reduction of signal paths in a semiconductor package and reduction of the size of the semiconductor package, a capacitor with high capacity which can be mounted in or under a semiconductor package is required.

[Technical Problem]

The present invention is directed to providing an ultra-small and high-capacity capacitor.

[Technical Solution]

One aspect of the present invention provides a capacitor which includes a base including a plurality of through-holes passing from a first surface to a second surface which is a surface opposite to the first surface, a first electrode layer disposed on the first surface and the second surface of the base and inner walls of the plurality of through-holes, a first dielectric layer disposed on the first electrode layer on the first surface and the second surface of the base and the inner walls of the plurality of through-holes, and a second electrode layer disposed on the first dielectric layer on the first surface and the second surface of the base and the inner walls of the plurality of through-holes.

The base may include silicon or anodic aluminum oxide (AAO).

A width of each of the plurality of through-holes may range from 10 nm to 1 $\mu$m.

A length of each of the plurality of through-holes may range from 10 nm to 100 $\mu$m.

Each of the first electrode layer and the second electrode layer may include at least one of titanium (Ti), molybdenum (Mo), tungsten (W), and indium-tin.

The first dielectric layer may include at least of $SiO_2$, $Si_3N_3$, $HfO_2$, $ZrO_2$, $Hf_xZr_yO_z$, and $Al_2O_3$.

The capacitor may further include a filler disposed on the second electrode layer of the inner walls of the plurality of through-holes to fill the plurality of through-holes.

The filler may include $Al_2O_3$.

The capacitor may further include a first electrode pad connected to the first electrode layer and a second electrode pad connected to the second electrode layer.

The capacitor may further include an insulating layer disposed on the second electrode layer on the first surface of the base, wherein the insulating layer may include a first opening in which the first electrode pad is disposed and a second opening in which the second electrode pad is disposed, the insulating layer may extend along an edge of the first opening to the first dielectric layer, and the first dielectric layer may include a first hole corresponding to the first opening.

The capacitor may further include a second dielectric layer disposed on the second electrode layer on the first surface and the second surface of the base and the inner walls the plurality of through-holes and a third electrode layer disposed on the second dielectric layer on the first surface and the second surface of the base and the inner walls of the plurality of through-holes.

The capacitor may further include a third electrode pad connected to the third electrode layer and an insulating layer disposed on the third electrode layer on the first surface of the base, wherein the insulating layer may include a first opening in which the first electrode pad is disposed, a second opening in which the second electrode pad is disposed, and a third opening in which the third electrode pad is disposed.

The insulating layer may extend along an edge of the first opening to the second dielectric layer, the second dielectric layer may include a first hole corresponding to the first opening, the second dielectric layer may extend along an edge of the first hole to the first dielectric layer, and the first dielectric layer may include a second hole corresponding to the first hole.

The insulating layer may extend along an edge of the second opening to the second dielectric layer, and the second dielectric layer may include a third hole corresponding to the second opening.

[Advantageous Effects]

According to embodiments of the present invention, an ultra-small high-capacity capacitor can be provided. In addition, according to embodiments of the present invention, a capacitor with a simple manufacturing process, a low cost, and high reliability can be provided.

[Description of Drawings]

FIG. 1 is a perspective view illustrating a capacitor according to an embodiment of the present invention.

FIG. 2 is a perspective view illustrating a base included in the capacitor according to the embodiment of the present invention.

FIGS. 3 to 5 are cross-sectional views illustrating the capacitor according to the embodiment of the present invention.

FIG. 6 is a cross-sectional view illustrating a capacitor according to another embodiment of the present invention.

FIGS. 7 and 8 show a method of manufacturing a capacitor according to an embodiment of the present invention.

FIGS. 9 and 10 are cross-sectional views illustrating a capacitor according to still another embodiment of the present invention.

[Modes of the Invention]

Hereinafter, exemplary embodiments of the present invention will be described in detail with reference to the accompanying drawings.

However, the technical spirit of the present invention is not limited to some embodiments which will be described and may be implemented in a variety of different forms, and one or more components of the embodiments may be selectively combined, substituted, and used within the range of the technical spirit of the present invention.

In addition, unless clearly and specifically defined otherwise by the context, all terms (including technical and scientific terms) used herein can be interpreted as having meanings customarily understood by those skilled in the art, and the meanings of generally used terms, such as those defined in commonly used dictionaries, will be interpreted in consideration of contextual meanings of the related art.

In addition, the terms used in the embodiments of the present invention are considered in a descriptive sense only and not to limit the present invention.

In the present specification, unless specifically indicated otherwise by the context, singular forms include plural forms, and in a case in which "at least one (or one or more) among A, B, and C" is described, this may include at least one combination among all possible combinations of A, B, and C.

In addition, in descriptions of components of the present invention, terms such as "first," "second," "A," "B," "(a)," and "(b)" may be used.

The terms are only to distinguish one component from another component, and the essence, order, and the like of the components are not limited by the terms.

In addition, when a first component is referred to as being "connected," "coupled," or "linked" to a second component, such a description may include both a case in which the first component is directly connected, coupled, or linked to the second component, and a case in which the first component is connected, coupled, or linked to the second component with a third component disposed therebetween.

In addition, when a first component is described as being formed or disposed "on (above)" or "under (below)" a second component, such a description includes both a case in which the two components are formed or disposed in direct contact with each other and a case in which one or more other components are formed or disposed between the two components. In addition, when a first component is described as being formed "on (above) or under (below)" a second component, such a description may include a case in which the first component is formed at an upper side or a lower side with respect to the second component.

Hereinafter, when embodiments are described in detail with reference to the accompanying drawings, components that are the same or correspond to each other will be denoted by the same or corresponding reference numerals in all drawings, and redundant descriptions will be omitted.

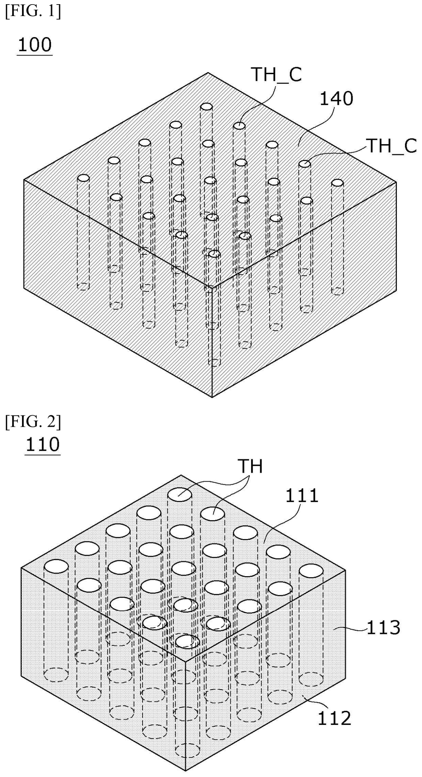

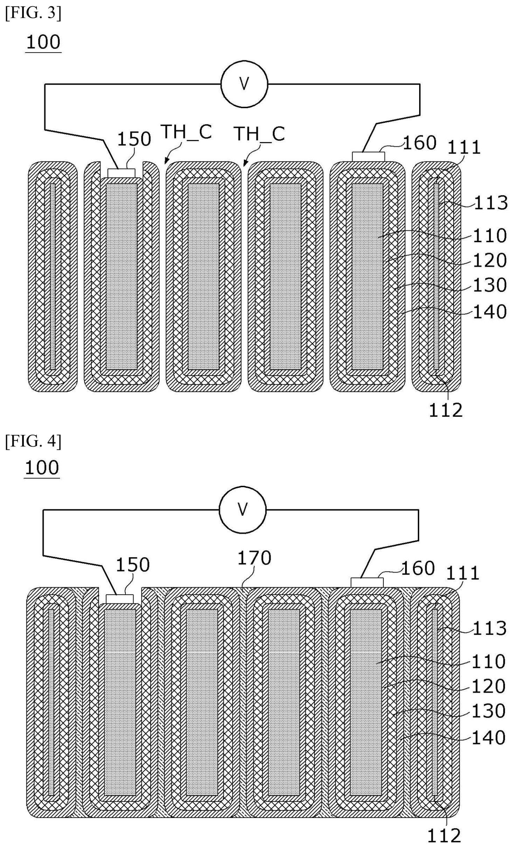

FIG. 1 is a perspective view illustrating a capacitor according to an embodiment of the present invention, FIG. 2 is a perspective view illustrating a base included in the capacitor according to the embodiment of the present invention, and FIGS. 3 to 5 are cross-sectional views illustrating the capacitor according to the embodiment of the present invention.

Referring to FIGS. 1 to 5, capacitors 100 each include a base 110, a first electrode layer 120, a first dielectric layer 130, and a second electrode layer 140.

As illustrated in FIG. 2, the base 110 includes a first surface 111, a second surface 112 which is a surface opposite to the first surface 111, and a third surface 113 disposed between the first surface 111 and the second surface 112. The first surface 111, the second surface 112, and the third surface 113 may be referred to as an upper surface, a lower surface, and a side surface, respectively. It is illustrated that the base 110 is formed in a hexahedral shape, but the present invention is not limited thereto. The base 110 may be formed in a cylindrical, elliptical cylindrical, or prismatic shape or the like.

The base 110 may include a semiconductor material or nonconductive material. For example, the base 110 may include silicon (Si) or anodic aluminum oxide (AAO) but is not limited thereto.

According to the embodiment of the present invention, the base 110 includes a plurality of through-holes TH passing from the first surface 111 to the second surface 112. That is, the plurality of through-holes TH extend from the first surface 111 to the second surface 112 of the base 110. In this case, at least some of the plurality of through-holes TH may be in parallel. For example, a virtual line connecting a center of the first surface 111 to a center of the second surface 112 corresponding to one of the plurality of through-holes TH may be parallel to a virtual line connecting a center of the first surface 111 and a center of the second surface 112 corresponding to another of the plurality of through-holes TH. Accordingly, since the electrode layer with a uniform thickness may be deposited on inner walls of the plurality of through-holes TH, a high reliability capacitor can be obtained.

According to the embodiment of the present invention, a width of some of the plurality of through-holes TH may range from 10 nm to 1 $\mu$m, preferably from 10 nm to 500 nm, and more preferably from 10 nm to 200 nm, and a length of each of the plurality of through-holes TH may range from 10 nm to 100 $\mu$m, preferably from 50 nm to 10 $\mu$m, and more preferably from 100 nm to 5 $\mu$m. In this case, since the plurality of through-holes TH passes through the first surface 111 which is the upper surface of the base 110 and the second surface 112 which is the lower surface, the length of each of the plurality of through-holes TH may be the same as a thickness of the base 110. When the width and the length of each of the plurality of through-holes TH are in such value ranges, it may be easy to form the plurality of through-holes TH in the base 110, and since the electrode layer with a uniform thickness may be deposited on the inner walls of the plurality of through-holes TH, the high reliability capacitor can be obtained.

According to the embodiment of the present invention, the first electrode layer 120 is disposed on the base 110, the first dielectric layer 130 is disposed on the first electrode layer 120, the second electrode layer 140 is disposed on the first dielectric layer 130, a first electrode pad 150 is connected to the first electrode layer 120, and a second electrode pad 160 is connected to the second electrode layer 140.

A capacitance of a capacitor may be calculated according to Equation 1 below.

$$[\text{Equation 1}]$$

$$C = \varepsilon \frac{S}{d}$$

Here, C is a capacitance, $\varepsilon$ is a dielectric permittivity, S is an area of an electrode layer, and d is a distance between electrode layers. Accordingly, it can be seen that a capacitance increases as an area of an electrode layer increases. According to the embodiment of the present invention, a capacitance is increased using an area of the electrode layer.

More specifically, as illustrated in FIGS. 3 to 5, the first electrode layer 120 is disposed on the first surface 111, the second surface 112, and the third surface 113 of the base 110 and the inner walls of the plurality of through-holes TH. As described above, when the first electrode layer 120 is disposed on the second surface 112 and the third surface 113 as well as the first surface 111 of the base 110 and the inner walls of the plurality of through-holes TH, since an area of the first electrode layer 120 is increased, the capacitance of the capacitor can be increased in the case of the same volume.

In this case, the first electrode layer 120 may include at least one of titanium (Ti), molybdenum (Mo), tungsten (W), and indium-tin. For example, the first electrode layer 120 may include at least one of TiN, $TiO_2$, $MoO_x$, $WO_x$, indium tin oxide (ITO), and indium tin gallium oxide (ITGO), and here, x is a positive integer. A thickness of the first electrode layer 120 may range from 1 to 50 nm, preferably from 1 to 40 nm, and more preferably from 1 to 30 nm. When the material and the thickness of the first electrode layer 120 satisfy such conditions, it can be easy to deposit the first electrode layer 120 with a uniform thickness on the base 110, and a capacitor with high response speed and high performance can be obtained.

Next, the first dielectric layer 130 is disposed on the first electrode layer 120 on the first surface 111, the second surface 112, and the third surface 113 of the base 110 and the inner walls of the plurality of through-holes TH. As described above, when the first dielectric layer 130 is disposed on the second surface 112 and the third surface 113 as well as the first surface 111 of the base 110 and the inner walls of the plurality of through-holes TH, the capacitance of the capacitor can be increased in the case of the same volume.

In this case, the first dielectric layer 130 may include at least one of $SiO_2$, $Si_3N_3$, $HfO_2$, $ZrO_2$, $Hf_xZr_yO_z$, and $Al_2O_3$, and here, x, y, and z are positive integers. When the material of the first dielectric layer 130 satisfies such a condition, it may be easy to deposit the first dielectric layer 130 with a uniform thickness on the first electrode layer 120.

The thickness of the first dielectric layer 130 may range from 1 to 50 nm, preferably from 1 to 40 nm, more preferably from 1 to 20 nm, and much more preferably from 1 to 15 nm. For example, the thickness of the first dielectric layer 130 may be smaller than the thickness of the first electrode layer 120. When the thickness of the first dielectric layer 130 satisfies such conditions, the capacitance of the capacitor can be increased in the case of the same volume.

Next, the second electrode layer 140 is disposed on the first dielectric layer 130 on the first surface 111, the second surface 112, and the third surface 113 of the base 110 and the inner walls of the plurality of through-holes TH. As described above, when the second electrode layer 140 is disposed on the second surface 112 and the third surface 113 as well as the first surface 111 of the base 110 and the inner walls of the plurality of through-holes TH, since an area of the second electrode layer 140 is increased, the capacitance of the capacitor can be increased in the case of the same volume.

In this case, the second electrode layer 140 may include at least one of titanium (Ti), molybdenum (Mo), tungsten (W), and indium-tin. For example, the second electrode layer 140 may include at least one of TiN, $TiO_2$, $MoO_x$, $WO_x$, ITO, and ITGO, and here, x is a positive integer. A thickness of the second electrode layer 140 may range from 1 to 50 nm, preferably from 1 to 40 nm, and more preferably from 1 to 30 nm. When the material and the thickness of the second electrode layer 140 satisfy such conditions, it may be easy to deposit the second electrode layer 140 with a uniform thickness on the first dielectric layer 130, and the capacitor with high response speed and high performance can be obtained.

The material of the second electrode layer 140 may be the same as the material of the first electrode layer 120 but is not limited thereto. That is, the material of the second electrode layer 140 may be different from the material of the first electrode layer 120.

According to the embodiment of the present invention, as illustrated in FIG. 3, the first electrode layer 120, the first dielectric layer 130, and the second electrode layer 140 are sequentially stacked on the inner wall of the through-hole TH of the base 110. In this case, the second electrode layer 140 at one side of the inner wall of the through-hole TH may be disposed to be spaced apart from the second electrode layer 140 at the other side of the same inner wall of the through-hole TH. That is, a through-hole TH_C corresponding to the through-hole TH of the base 110 may be formed in the capacitor 100, and a width of the through-hole TH_C of the capacitor 100 may be smaller than a width of the through-hole TH of the base 110.

Alternatively, as illustrated in FIG. 4, the second electrode layer 140 at one side of the inner wall of the through-hole TH is disposed to be spaced apart from the second electrode layer 140 at the other side of the same inner wall of the through-hole TH, the through-hole TH_C corresponding to the through-hole TH of the base 110 is formed in the capacitor 100, and the through-hole TH_C of the capacitor 100 may be filled with a filler 170. In this case, the filler 170 may be a material with an insulation property of which a thermal expansion coefficient is smaller than that of the second electrode layer 140. For example, the filler 170 may include $Al_2O_3$. Accordingly, even when a temperature of the capacitor 100 increases, since an inner portion of the through-hole TH_C of the capacitor 100 does not expand thermally, the capacitor 100 with high reliability can be obtained.

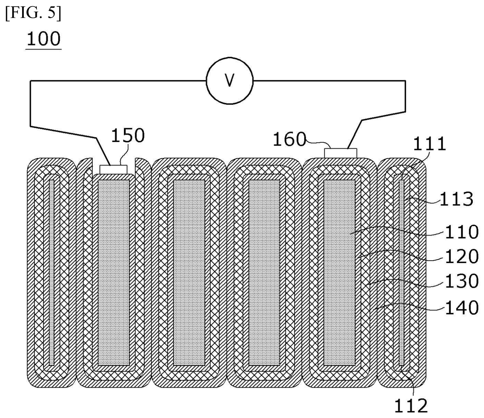

Alternatively, as illustrated in FIG. 5, the second electrode layer 140 at one side of the inner wall of the through-hole TH may also be disposed in contact with the second electrode layer 140 at the other side of the same inner wall of the through-hole TH. Accordingly, since a total resistance of the capacitor 100 is decreased, the capacitor with high response speed can be obtained.

Meanwhile, an example in which the first electrode layer 120, first dielectric layer 130, and the second electrode layer 140 are sequentially stacked on the base 110 has been mainly described, but the present invention is not limited thereto. According to the embodiment of the present invention, a dielectric layer and an electrode layer may also be further disposed alternately on the second electrode layer 140.

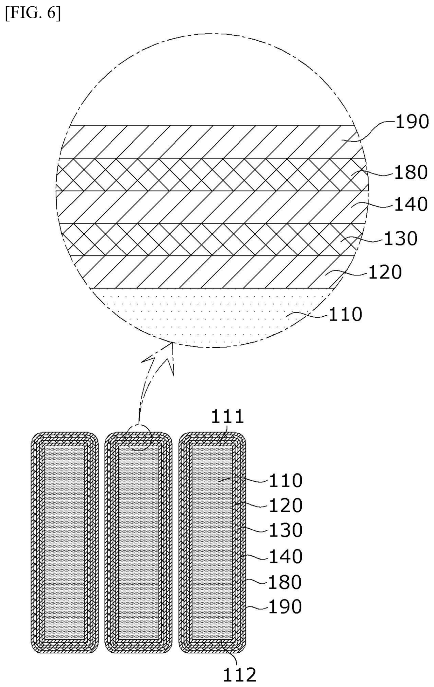

FIG. 6 is a cross-sectional view illustrating a capacitor according to another embodiment of the present invention. For the sake of convenience in the description, overlapping description of content which is the same as that described with reference to FIGS. 1 to 5 will be omitted.

Referring to FIG. 6, a second dielectric layer 180 is disposed on a second electrode layer 140 on a first surface 111, a second surface 112, and a third surface 113 of a base 110 and inner walls of a plurality of through-holes TH. As described above, when the second dielectric layer 180 disposed on the second surface 112 and the third surface 113 as well as the first surface 111 of the base 110 and the inner walls of the plurality of through-holes TH, a capacitance of the capacitor can be increased in the case of the same volume.

In this case, the second dielectric layer 180 may include at least one of $SiO_2$, $Si_3N_3$, $HfO_2$, $ZrO_2$, $Hf_xZr_yO_z$, and $Al_2O_3$, and here, x, y, and z are positive integers. When the material of the second dielectric layer 180 satisfies such a condition, it may be easy to deposit the second dielectric layer 140 with a uniform thickness on the second electrode layer 140.

The thickness of the second dielectric layer 180 may range from 1 to 50 nm, preferably from 1 to 40 nm, more preferably from 1 to 20 nm, and much more preferably from 1 to 15 nm. For example, the thickness of the second dielectric layer 180 may be smaller than a thickness of the second electrode layer 140. When the thickness of the second dielectric layer 180 satisfies such conditions, the capacitance of the capacitor can be increased in the case of the same volume.

Next, a third electrode layer 190 is disposed on the second dielectric layer 180 on the first surface 111, the second surface 112, and the third surface 113 of the base 110 and the inner walls of the plurality of through-holes TH. As described above, when the third electrode layer 190 is disposed on the second surface 112 and the third surface 113 as well as the first surface 111 of the base 110 and the inner walls of the plurality of through-holes TH, since an area of the third electrode layer 190 is increased, the capacitance of the capacitor can be increased in the case of the same volume.

In this case, third electrode layer 190 may include at least one of titanium (Ti), molybdenum (Mo), tungsten (W), and indium-tin. For example, the third electrode layer 190 may include at least one of TiN, $TiO_2$, $MoO_x$, $WO_x$, ITO, and ITGO, and here, x is a positive integer. A thickness of the third electrode layer 190 may range from 1 to 50 nm, preferably from 1 to 40 nm, and more preferably from 1 to 30 nm. When the material and the thickness of third electrode layer 190 satisfy such conditions, it may be easy to deposit the third electrode layer 190 with a uniform thickness on the second dielectric layer 180, and the capacitor with high response speed and high performance can be obtained.

The material of the third electrode layer 190 may be the same as the material of a first electrode layer 120 and the second electrode layer 140 but is not limited thereto. That is, the material of the third electrode layer 190 may be different from the material of the first electrode layer 120 and the second electrode layer 140.

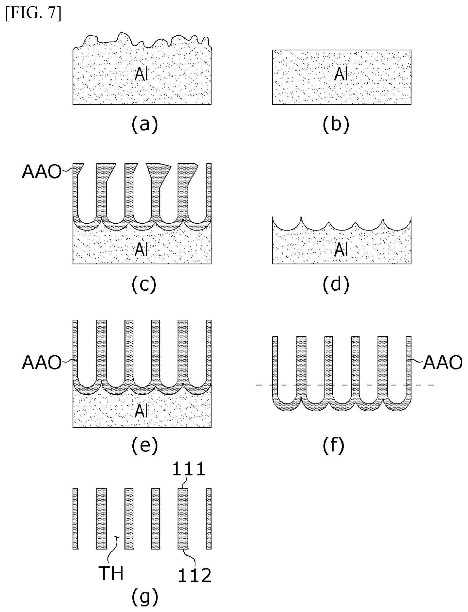

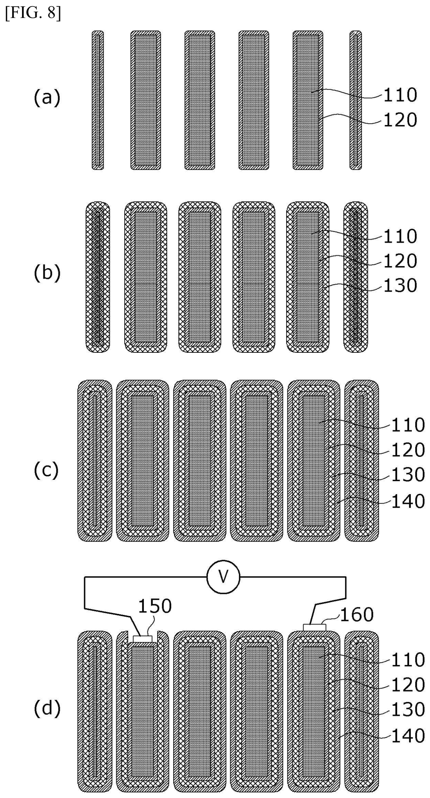

FIGS. 7 and 8 show a method of manufacturing a capacitor according to an embodiment of the present invention.

Referring to FIG. 7A, an aluminum substrate is prepared. In this case, the aluminum substrate may be an aluminum substrate containing aluminum at 90% or more, preferably 99% or more, and more preferably 99.999% or more. In this case, the aluminum substrate may have a rough surface.

Referring to FIGS. 7B, the surface of the aluminum substrate is electrochemically polished. Accordingly, the surface of the aluminum substrate may be planarized.

Referring to FIG. 7C, a first anodic oxidation process is performed on the planarized surface of the aluminum substrate. Accordingly, an AAO may be grown on the aluminum substrate. In this case, the AAO may be grown through a wet process. Accordingly, the AAO having pores with a predetermined width may be grown on the aluminum substrate. In this case, the AAO grown through the first anodic oxidation process may not be uniform.

Referring to FIG. 7D, the AAO on the aluminum substrate is removed through a wet etching.

Referring to FIG. 7E, a second anodic oxidation process is performed on the aluminum substrate from which the AAO grown by the first anodic oxidation process is removed. Accordingly, an AAO may be grown on the aluminum substrate to be more uniform than the AAO grown in the first anodic oxidation process. In this case, when a solvent, a temperature, a time, and a voltage of the second anodic oxidation process are controlled, a size of a pore, a length of the AAO, or the like may be adjusted.

Referring to FIG. 7F, the aluminum substrate is removed through a wet etching.

Referring to FIG. 7G, a lower portion of the AAO, that is, a region in contact with the aluminum substrate, is removed through a wet etching.

Accordingly, referring to FIG. 7H, a base 110 including a plurality of through-holes TH passing from a first surface 111 to a second surface 112 may be obtained.

Next, referring to FIG. 8A, a first electrode layer 120 is deposited on the base 110. The first electrode layer 120 may be deposited using an atomic layer deposition (ALD) process. When the ALD process is used, a material of the first electrode layer 120 may be conformally disposed on the surface of the base 110 in units of atoms. Accordingly, the first electrode layer 120 may be uniformly disposed on the second surface 112 and a third surface 113 as well as the first surface 111 of the base 110 and an inner wall of a through-hole TH.

Next, referring to FIG. 8B, a first dielectric layer 130 is deposited on the first electrode layer 120. The first dielectric layer 130 may be deposited using an ALD process. Accordingly, a material of the first dielectric layer 130 may be conformally disposed on a surface of the first electrode layer 120 in units of atoms. Accordingly, the first dielectric layer 130 may be disposed on the first electrode layer 120 of the second surface 112 and the third surface 113 as well as the first surface 111 of the base 110 and the inner wall of the through-hole TH.

Next, referring to FIG. 8C, a second electrode layer 140 is deposited on the first dielectric layer 130. The second electrode layer 140 may be deposited using an ALD process. Accordingly, a material of the second electrode layer 140 may be conformally deposited on a surface of the first dielectric layer 130 in units of atoms. Accordingly, the second electrode layer 140 may be uniformly deposited on the first dielectric layer 130 of the second surface 112 and the third surface 113 as well as the first surface 111 of the base 110 and the inner wall of the through-hole TH.

Next, referring to FIG. 8D, a first electrode pad 150 is connected to the first electrode layer 120, and a second electrode pad 160 is connected to the second electrode layer 140. In order to connect the first electrode pad 150 to the first electrode layer 120, the second electrode layer 140 and the first dielectric layer 130 may be etched. In addition, the first electrode pad 150 and the second electrode pad 160 may be deposited by a sputtering.

In this case, it has been mainly described that the method of manufacturing the capacitor in which the base includes the AAO, an embodiment of the present invention is not limited thereto. The capacitor according to the embodiment of the present invention may be a silicon-based capacitor in which a base includes silicon.

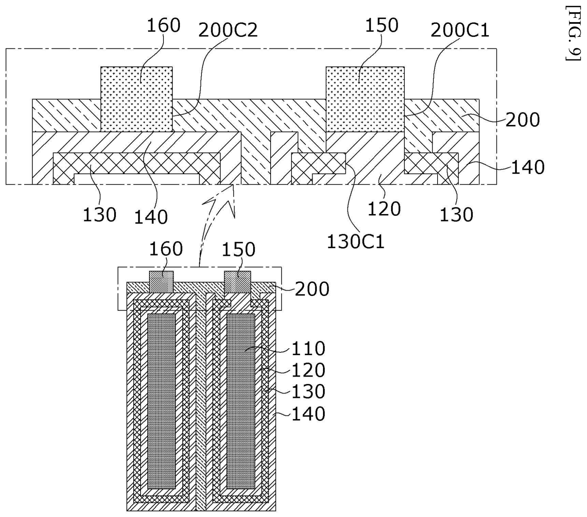

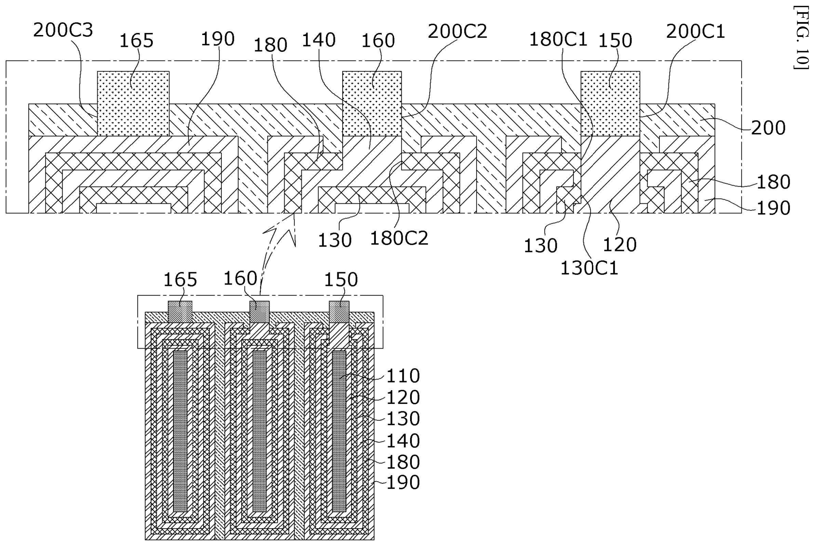

FIGS. 9 and 10 are cross-sectional views illustrating a capacitor according to still another embodiment of the present invention. For the sake of convenience in the description, overlapping description of content which is the same as that described with reference to FIGS. 1 to 8 will be omitted.

Referring to FIG. 9, a capacitor 100 includes a base 110, a first electrode layer 120 disposed on the base 110, a first dielectric layer 130 disposed on the first electrode layer 120, a second electrode layer 140 disposed on the first dielectric layer 130, a first electrode pad 150 connected to the first electrode layer 120, and a second electrode pad 160 connected to the second electrode layer 140.

According to the embodiment of the present invention, in order to arrange the first electrode pad 150 and the second electrode pad 160, the capacitor 100 further includes an insulating layer 200 disposed on the second electrode layer 140 on a first surface 111 of the base 110. As illustrated in the drawing, the insulating layer 200 may extend into a through-hole TH to serve as a filler 170.

The insulating layer 200 includes a first opening 200C1 and a second opening 200C2 above the second electrode layer 140 of the first surface 111 of the base 110. The first electrode pad 150 may be disposed in the first opening 200C1, and the second electrode pad 160 may be disposed in the second opening 200C2. Accordingly, the second electrode pad 160 disposed in the second opening 200C2 may be connected to the second electrode layer 140. In order to connect the first electrode pad 150 disposed in the first opening 200C1 to the first electrode layer 120, the insulating layer 200 may extend along an edge of the first opening 200C1 to the first dielectric layer 130, and the first dielectric layer 130 may include a first hole 130C1 corresponding to the first opening 200C1. Accordingly, the first electrode pad 150 may be connected to the first electrode layer 120.

When the first electrode pad 150 and the second electrode pad 160 are disposed according to the above structure, upper surfaces of the first electrode pad 150 and the second electrode pad 160 may be disposed to have the same height. Accordingly, when the capacitor 100 according to the embodiment of the present invention is mounted on a printed circuit bord, since the heights of the first electrode pad 150 and the second electrode pad 160 do not need to be additionally adjusted, an assembly process can be improved, and a bonding force between the first electrode pad 150 and second electrode pad 160 and the printed circuit bord can be improved.

Referring to FIG. 10, a capacitor 100 includes a base 110, a first electrode layer 120 disposed on the base 110, a first dielectric layer 130 disposed on the first electrode layer 120, a second electrode layer 140 disposed on the first dielectric layer 130, a second dielectric layer 180 disposed on the second electrode layer 140, a third electrode layer 190 disposed on a second dielectric layer 180, a first electrode pad 150 connected to the first electrode layer 120, a second electrode pad 160 connected to the second electrode layer 140, and a third electrode pad 165 connected to the third electrode layer 190.

According to the embodiment of the present invention, in order to arrange the first electrode pad 150, the second electrode pad 160, and the third electrode pad 165, the capacitor 100 further includes an insulating layer 200 disposed on the third electrode layer 190 on a first surface 111 of the base 110. As illustrated in the drawing, the insulating layer 200 may extend into a through-hole TH to serve as a filler 170.

The insulating layer 200 includes a first opening 200C1, a second opening 200C2, and a third opening 200C3 in the third electrode layer 190 on the first surface 111 of the base 110. The first electrode pad 150 may be disposed in the first opening 200C1, the second electrode pad 160 may be disposed in the second opening 200C2, and the third electrode pad 165 may be disposed in the third opening 200C3. Accordingly, the third electrode pad 165 disposed in the third opening 200C3 may be connected to the third electrode layer 190.

In order to connect the first electrode pad 150 disposed in the first opening 200C1 to the first electrode layer 120, the insulating layer 200 may extend along an edge of the first opening 200C1 to the second dielectric layer 180, and the second dielectric layer 180 may include a first hole 180C1 corresponding to the first opening 200C1. In addition, the second dielectric layer 180 may extend along an edge of the first hole 180C1 to the first dielectric layer 130, and the first dielectric layer 130 may include a second hole 130C1 corresponding to the first hole 180C1. Accordingly, the first electrode pad 150 may be connected to the first electrode layer 120.

In order to connect the second electrode pad 160 disposed in the second opening 200C2 to the second electrode layer 140, the insulating layer 200 may extend along an edge of the second opening 200C2 to the second dielectric layer 180, and the second dielectric layer 180 may include a third hole 180C2 corresponding to the second opening 200C2. Accordingly, the second electrode pad 160 may be connected to the second electrode layer 140.

When the first electrode pad 150, the second electrode pad 160, and the third electrode pad 165 are disposed according to the above structure, upper surfaces of the first electrode pad 150, the second electrode pad 160, and the third electrode pad 165 may be disposed to have the same height. Accordingly, when the capacitor 100 according to the embodiment of the present invention is mounted on a printed circuit bord, since the heights of the first electrode pad 150, the second electrode pad 160, and the third electrode pad 165 do not need to be additionally adjusted, an assembly process can be improved, and a bonding force between the first electrode pad 150, second electrode pad 160, and third electrode pad 165 and the printed circuit bord can be improved.

While the present invention has been described above with reference to exemplary embodiments, it may be understood by those skilled in the art that various modifications and changes of the present invention may be made within a range that does not depart from the spirit and scope of the present invention defined by the appended claims.

**Claims**

1. A capacitor comprising:

a base including a plurality of through-holes passing from a first surface to a second surface which is a surface opposite to the first surface;

a first electrode layer disposed on the first surface and the second surface of the base and inner walls of the plurality of through-holes; a first dielectric layer disposed on the first electrode layer on the first surface and the second surface of the base and the inner walls of the plurality of through-holes; and a second electrode layer disposed on the first dielectric layer on the first surface and the second surface of the base and the inner walls of the plurality of through-holes.

2. The capacitor of claim 1, wherein the base includes silicon or anodic aluminum oxide (AAO).

3. The capacitor of claim 1, wherein a width of each of the plurality of through-holes ranges from 10 nm to 1 $\mu$m.

4. The capacitor of claim 1, wherein a length of each of the plurality of through-holes ranges from 10 nm to 100 $\mu$m.

5. The capacitor of claim 1, further comprising a filler disposed on the second electrode layer of the inner walls of the plurality of through-holes to fill the plurality of through-holes.

6. The capacitor of claim 5, wherein the filler includes $Al_2O_3$.

7. The capacitor of claim 1, further comprising:

   a first electrode pad connected to the first electrode layer; and a second electrode pad connected to the second electrode layer.

8. The capacitor of claim 7, further comprising an insulating layer disposed on the second electrode layer on the first surface of the base,

   wherein the insulating layer includes a first opening in which the first electrode pad is disposed and a second opening in which the second electrode pad is disposed, the insulating layer extends along an edge of the first opening to the first dielectric layer, and the first dielectric layer includes a first hole corresponding to the first opening.

9. The capacitor of claim 7, further comprising:

   a second dielectric layer disposed on the second electrode layer on the first surface and the second surface of the base and the inner walls the plurality of through-holes; and a third electrode layer disposed on the second dielectric layer on the first surface and the second surface of the base and the inner walls of the plurality of through-holes.

10. The capacitor of claim 9, further comprising:

   a third electrode pad connected to the third electrode layer; and an insulating layer disposed on the third electrode layer on the first surface of the base, wherein the insulating layer includes a first opening in which the first electrode pad is disposed, a second opening in which the second electrode pad is disposed, and a third opening in which the third electrode pad is disposed.

[FIG. 1]

<u>100</u>

TH_C
140
TH_C

[FIG. 2]

<u>110</u>

TH
111
113
112

[FIG. 3]

100

[FIG. 4]

100

[FIG. 5]

100

[FIG. 6]

[FIG. 7]

(a)

(b)

AAO

(c)

(d)

AAO

(e)

AAO

(f)

111

TH    112

(g)

[FIG. 8]

[FIG. 9]

[FIG. 10]

## INTERNATIONAL SEARCH REPORT

| International application No. |
|---|
| **PCT/KR2024/000081** |

| A. | CLASSIFICATION OF SUBJECT MATTER |
|---|---|

**H01G 4/236**(2006.01)i; **H01L 23/64**(2006.01)i; **H01G 4/12**(2006.01)i

According to International Patent Classification (IPC) or to both national classification and IPC

| B. | FIELDS SEARCHED |
|---|---|

Minimum documentation searched (classification system followed by classification symbols)

H01G 4/236(2006.01); H01G 4/228(2006.01); H01G 4/30(2006.01); H01G 4/33(2006.01); H01G 4/35(2006.01); H01L 21/283(2006.01); H01L 21/3213(2006.01); H01L 21/8242(2006.01); H01L 27/02(2006.01); H01L 27/108(2006.01); H05K 1/18(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 관통홀(through hole), 베이스(base), 전극층(electrode layer), 유전체층(dielectric layer), 캐패시터(capacitor)

| C. | DOCUMENTS CONSIDERED TO BE RELEVANT |
|---|---|

| Category* | Citation of document, with indication, where appropriate, of the relevant passages | Relevant to claim No. |
|---|---|---|
| X | JP 2020-027821 A (TAIYO YUDEN CO., LTD.) 20 February 2020 (2020-02-20)<br>See paragraphs [0029]-[0047] and figure 2. | 1-4,7-8 |
| Y | | 5-6,9-10 |
| Y | KR 10-2013-0132519 A (TESSERA, INC.) 04 December 2013 (2013-12-04)<br>See paragraphs [0027]-[0061] and figure 2g. | 5-6,9-10 |
| A | US 2016-0268144 A1 (IPDIA et al.) 15 September 2016 (2016-09-15)<br>See paragraphs [0059]-[0127] and figure 1. | 1-10 |
| A | US 2009-0159322 A1 (WU, Bang-Hao et al.) 25 June 2009 (2009-06-25)<br>See paragraphs [0024]-[0034] and figures 2-4. | 1-10 |

| ✓ Further documents are listed in the continuation of Box C. | ✓ See patent family annex. |
|---|---|

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **08 April 2024** | **08 April 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT

| International application No. |
| --- |
| **PCT/KR2024/000081** |

### C. DOCUMENTS CONSIDERED TO BE RELEVANT

| Category* | Citation of document, with indication, where appropriate, of the relevant passages | Relevant to claim No. |
| --- | --- | --- |
| A | KR 10-2014-0011766 A (SAMSUNG ELECTRO-MECHANICS CO., LTD.) 29 January 2014 (2014-01-29)<br>See paragraphs [0038]-[0099] and figures 1-6. | 1-10 |

Form PCT/ISA/210 (second sheet) (July 2022)

### INTERNATIONAL SEARCH REPORT
**Information on patent family members**

International application No.

**PCT/KR2024/000081**

| Patent document cited in search report | | | Publication date (day/month/year) | Patent family member(s) | | | Publication date (day/month/year) |
|---|---|---|---|---|---|---|---|
| JP | 2020-027821 | A | 20 February 2020 | JP | 7160594 | B2 | 25 October 2022 |
| | | | | US | 11309134 | B2 | 19 April 2022 |
| | | | | US | 2020-0051749 | A1 | 13 February 2020 |
| KR | 10-2013-0132519 | A | 04 December 2013 | CN | 107045972 | B | 05 May 2020 |
| | | | | EP | 4102585 | A3 | 22 March 2023 |
| | | | | JP | 6329977 | B2 | 23 May 2018 |
| | | | | KR | 10-2012-0064610 | A | 19 June 2012 |
| | | | | TW | I546833 | B | 21 August 2016 |
| | | | | US | 11004930 | B2 | 11 May 2021 |
| | | | | WO | 2012-079013 | A1 | 14 June 2012 |
| US | 2016-0268144 | A1 | 15 September 2016 | CN | 105706234 | A | 22 June 2016 |
| | | | | CN | 105706234 | B | 12 October 2018 |
| | | | | EP | 3063789 | A1 | 07 September 2016 |
| | | | | EP | 3063789 | B1 | 19 July 2023 |
| | | | | FR | 3012664 | A1 | 01 May 2015 |
| | | | | FR | 3012664 | B1 | 01 January 2016 |
| | | | | JP | 2016-535441 | A | 10 November 2016 |
| | | | | JP | 6543622 | B2 | 10 July 2019 |
| | | | | TW | 201530727 | A | 01 August 2015 |
| | | | | TW | I689071 | B | 21 March 2020 |
| | | | | US | 10497582 | B2 | 03 December 2019 |
| | | | | WO | 2015-063420 | A1 | 07 May 2015 |
| US | 2009-0159322 | A1 | 25 June 2009 | CA | 2638533 | A1 | 11 September 2009 |
| | | | | TW | 200929500 | A | 01 July 2009 |
| | | | | TW | I373118 | B | 21 September 2012 |
| | | | | US | 7894178 | B2 | 22 February 2011 |
| KR | 10-2014-0011766 | A | 29 January 2014 | KR | 10-1396744 | B1 | 19 May 2014 |

Form PCT/ISA/210 (patent family annex) (July 2022)